# EUROPEAN PATENT APPLICATION

(11) **EP 4 293 914 A1**
(43) Date of publication of application: **20.12.2023**
(21) Application number: 22275080.4
(22) Date of filing: 16.06.2022
(51) Int. Cl.: H03M 1/36, G02F 7/00

(54) **ANALOGUE TO DIGITAL CONVERTER**

(71) Applicant: BAE SYSTEMS plc, London SW1Y 5AD (GB)
(72) Inventor: The designation of the inventor has not yet been filed
(74) Representative: BAE SYSTEMS plc Group IP Department

(57) **Abstract**

A method of performing analogue to digital conversion of an analogue input signal. The method comprises: obtaining a laser signal; modulating, using an electro-optic phase modulator, the laser signal on the basis of the analogue input signal; determining, on the basis of the modulated laser signal, a voltage of the analogue input signal; and generating a digital signal indicative of the determined voltage. An apparatus for performing analogue to digital conversion of an analogue input signal. The apparatus comprises an electro-optic phase modulator and a processor. The electro-optic phase modulator is configured to receive a laser signal and modulate the laser signal on the basis of the analogue input signal. The processor is configured to determine, on the basis of the modulated laser signal, a voltage of the analogue input signal and generate a digital signal indicative of the determined voltage.

## Description

### FIELD

The present invention concerns an apparatus for and a method of performing analogue-to-digital conversion of electrical signals.

### BACKGROUND

An analogue-to-digital converter (ADC) is conventionally an electronic component or subsystem which operates to convert an analogue electrical input signal into a digital signal indicative of a voltage of the input signal.

In recent years, developments in ADCs have yielded increases in ADC bandwidths. By contrast however, ADC dynamic ranges have not improved commensurately. In particular, the increased use of smaller transistor sizes, which can typically only tolerate low input voltages, has limited improvements in ADC dynamic ranges. Further limitation occurs as a result of timing uncertainty in electronic sampling. It will be understood by the skilled person that the dynamic range of an ADC refers to the range of input voltages it can process usefully.

In many contexts and applications, the dynamic range of an ADC is a limiting factor in the performance of a system. An example is a radio receiver where sensitivity to small signals is desirable but large signals are nonetheless present simultaneously. There is therefore a need for analogue to digital conversion systems with higher dynamic ranges.

Improved dynamic range at a system level can be achieved by passing the input signal through a power splitter and then sampling its outputs using multiple ADCs. Digital signal processing can then be used to determine the voltage of the input signal. This technique is known in the art as "ADC stacking". However, in such cases, the dynamic range of the system typically increases only linearly with the number of ADCs.

The present invention seeks to mitigate the above-mentioned problems. Alternatively or additionally, the present invention seeks to provide an improved method and apparatus for performing analogue-to-digital conversion of electrical signals.

### SUMMARY

According to a first aspect of the present invention, there is provided a method of performing analogue to digital conversion of an analogue input signal, the method comprising:
obtaining a laser signal;
modulating, using an electro-optic phase modulator, the laser signal on the basis of the analogue input signal;
determining, on the basis of the modulated laser signal, a change in voltage of the analogue input signal; and
generating a digital signal indicative of the determined change in voltage.

Performing analogue to digital conversion in this way can provide increased dynamic range. The parameter that encodes the input voltage (i.e. the phase of the laser) becomes folded within a more limited numerical range when viewed using a measurement system sensitive to within cycle phase. It will be appreciated by the skilled person that the term "phase" is, in this context, intended to encompass phase angles extending beyond a single cycle, whereas the term 'within cycle phase' is intended to encompass the remaining phase when whole numbers of cycles are removed. Thus, the "within cycle phase" can vary only from -π to +π.

By modulating, using an electro-optic phase modulator, the laser signal on the basis of the analogue input signal, the information embodied in the voltage of the analogue input signal is transposed onto the phase of the modulated laser signal. Thus, by tracking changes in the phase of the modulated laser signal, it is possible to determine changes in the voltage of the analogue input signal. The skilled person will understand that the phase of the modulated laser signal can vary independently of its amplitude (which can, for example, be kept substantially constant). Thus, a greater range of voltages of the analogue input signal (including voltages which might ordinarily saturate an input of a conventional analogue-to-digital converter) can be measured.

The modulating of the laser signal on the basis of the analogue input signal to transpose information embodied in the voltage of the signal onto the phase of the modulated laser can be considered as a form of pre-processing of the analogue input signal. This pre-processing can advantageously change the nature of the input signal prior to conventional analogue-to-digital conversion (for example, using electronic ADCs) whilst retaining its information content. In particular, it converts the signal from one having information encoded as a variation in the voltage of the signal to one having that information encoded as a variation in the phase of the signal. This can prevent excessive variation in the voltage of the analogue input signal saturating the apparatus, as this voltage variation is instead converted during the pre-processing into a phase shift of the modulated laser signal. Digital post-processing can then be used to obtain from the modulated laser signal (based on the phase shift of the modulated laser signal) a measurement of the voltage of the analogue input signal.

It will be appreciated by the skilled person that a laser comprises a beam of substantially monochromatic light. Thus, the laser signal may consist of light having only a single wavelength. It will also be appreciated by the skilled person that the laser signal will therefore have a phase.

It may be that the laser comprises a pulsed laser. Thus, it may be that the laser signal comprises a pulsed laser signal. A pulsed laser can be mode-locked, such that the laser signal pulse rate has extremely low timing jitter. This can provide reduced sampling jitter, and thereby reduced sampling errors (for example, when integrated with electronic sampling systems, such as ADCs).

It may be that obtaining the laser signal comprises generating the laser signal (for example, by operating a laser). Alternatively, it may be that the laser signal is received from an external source (for example, separate from the apparatus). It may be that such an external source is located apart from the apparatus. In such cases, it may be that the external source is connected to the apparatus by optic fibre (for example, to transmit the laser signal from the external source to the apparatus).

The analogue input signal may be an electrical signal. The analogue input signal may have a voltage that varies over time. It may be that a voltage of the analogue input signal varies between a first voltage and a second voltage.

It may be that the electro-optic phase modulator is configured to vary the phase of the modulated laser signal. Thus, the modulating gives rise to a phase difference between the laser signal and the modulated laser signal. It may be that the electro-optic phase modulator is configured to delay the modulated laser signal relative to the laser signal. It may be that the electro-optic phase modulator is configured to vary the phase of the modulated laser signal by varying the refractive index of a medium through which the laser signal travels. It will be appreciated by the skilled person that varying the refractive index of such a medium varies the velocity of the laser signal through the medium. It may be that the electro-optic phase modulator operates by means of the Pockels effect.

It may be that the modulating is performed on the basis of a voltage of the analogue input signal.

The modulating may be such that variation of the analogue input signal imparts on the laser signal a phase shift of greater than one cycle. Thus, the modulating may comprise phase shifting the modulated laser signal (for example, relative to the laser signal) by more than one cycle. It may be that the electro-optic phase modulator is configured to impart on the laser signal a first phase shift when the analogue input signal is at the first voltage. It may be that the electro-optic phase modulator is configured to impart on the laser signal a second phase shift when the analogue input signal is at the second voltage. In such cases, it may be that the difference between the first phase shift and second phase shift is more than one cycle. Thus, it may be that the modulated laser signal has a first phase when the analogue input signal is at the first voltage and a second phase when the analogue input signal is at the second voltage. In such cases, it may be that the first phase and the second phase are more than one cycle apart. Thus, it may be that, as the voltage of the analogue input signal increases from the first voltage to the second voltage, the phase of the modulated laser signal increases by more than one cycle.

It will be appreciated by the skilled person that phase shifting the laser signal by more than one cycle means that at least one possible within cycle phase of the modulated laser signal can be caused by more than one voltage of the analogue input signal. Thus, the within cycle phase output of the electro-optic phase modulator can be said to "fold" or "wrap-around". In such cases, at least one (for example, any given) within cycle phase output of the electro-optic phase modulator may be associated with more than one voltage of the analogue input signal. This effect can be exploited to provide an analogue to digital converter with improved dynamic range.

The modulating may be such that variation of the analogue input signal over its range imparts on the laser signal a phase shift of greater than two cycles (for example greater than five cycles or greater than ten cycles). Thus, the modulating may be such to cause the within cycle phase output of the electro-optic phase modulator to wrap around multiple times. This can be referred to as folding the output signal. The number of times the within cycle phase output of the electro-optic phase modulator wraps around can be referred to as a number of folds in the output signal. It will be appreciated by the skilled that having the within cycle phase output of the electro-optic phase modulator wrap around a greater number of times can provide a greater improvement in dynamic range.

The modulating may be such that the within cycle phase of the modulated laser signal varies substantially periodically as a voltage of the analogue input signal increases. In such cases, it may be that the modulating is such that variation of the analogue input signal causes the phase of the modulated laser signal to vary through multiple complete cycles. It will be appreciated by the skilled person that the phase shift applied to the modulated laser signal will not vary periodically (for example, it may vary substantially linearly) as a voltage of the analogue input signal increases but that, because the phase of the modulated laser signal is measured as an within cycle angle (i.e. between -π and +π radians), the phase of the modulated laser signal will appear to vary periodically when viewed using a within cycle phase measurement system (as, when the phase of the modulated laser signal reaches +π, it will wrap around to -π before continuing to increase). The modulating may be such that the within cycle phase of the modulated laser signal varies substantially as a sawtooth waveform for linear voltage increases.

It may be that the modulated laser signal has a plurality of possible phase states. It will be appreciated by the skilled person that, in this context, a phase state of the modulated laser signal refers to the within cycle phase shift applied to the modulated laser signal (for example, relative to the laser signal). In such cases, it may be that the modulating comprises causing the modulated laser signal to assume one of the plurality of possible phase states. The assumed phase state may be associated with the analogue input voltage (for example, by virtue of the modulating having been performed on the basis of the analogue input signal). It may be that the determining comprises evaluating the assumed phase state.

The determining of the change in voltage of the analogue input signal may comprise performing phase detection (for example, within cycle phase detection) of the modulated laser signal. In such cases, it may be that the determining comprises operating a phase detector (for example, a within cycle phase detector). Determining the change in voltage of the analogue input signal may comprise determining a change in phase of the modulated laser signal. It will be appreciated by the skilled person that certain types of phase detector, such as those exploiting the interference between a signal and a single frequency reference source, only respond to the within cycle phase shift between signal and reference. It may be that the phase detector is capable of measuring phase only over one cycle. Thus, it may be that the phase detector is only capable of outputting phase values between +π and -π. Where the modulating is such that variation of the analogue input signal causes the phase of the modulated laser signal to vary through more than one cycle, it will be appreciated by the skilled person that the output of the phase detector will, as the voltage of the analogue input signal increases, increase from -π to +π before "wrapping around" to -π again. Hence, the signal can be said to be "folded" back on itself. In this way, the information content of the analogue input signal (which can have a large dynamic range) can be transferred to a signal with a restricted dynamic range but higher bandwidth. In such cases, the electro-optic phase modulator and the phase detector (for example, the within cycle phase detector) can provide an optical signal folding function.

As previously mentioned, where the electro-optic phase modulator is configured to phase-shift the modulated laser signal by more than one cycle, a given within cycle phase output of the electro-optic phase modulator may be associated with more than one voltage of the analogue input signal. Thus, it may be that at least one of the plurality of possible phase states is associated with a plurality of possible voltages of the analogue input signal. In such cases, it may be that the determining comprises identifying which voltage in the plurality of possible voltages has caused the assumed phase state.

The identifying may comprise sampling the within cycle phase at a rate that is so frequent that the change in input voltage between samples is less than that required to cause a change in phase shift of a half cycle. It is thus possible to track changes in the input voltage by accumulating the changes between samples of the within cycle phase shifts to determine the changes in the phase shift, and therefore the changes in the input voltage over a period. If the input voltage is known at a particular time, then its current value may be derived by adding any observed changes. The skilled person will appreciate that, in many applications (including, for example, software defined radio), it is only the changes in the input voltage, rather than its starting value, that are important.

The identifying may be performed on the basis of one or more previously determined voltages of the analogue input signal. Thus, the identifying may be performed based on prior knowledge of the input signal. The method may comprise storing (for example, in memory) one or more previously determined voltages (for example, the one or more most recently determined voltages) of the analogue input signal. The identifying may be performed on the basis of a most recently determined voltage of the analogue input signal. In such cases, the identifying may comprise identifying one of the plurality of voltages which is closest to most recently determined voltage of the analogue input signal.

The method may further comprise operating an analogue-to-digital converter to convert the analogue input signal into a digitised input signal. In such embodiments, it may be that the analogue-to-digital converter has sufficient resolution to distinguish between within cycle phase states. In such cases, it may be that the identifying is performed on the basis of the digitised input signal. In such embodiments, the identifying may comprise identifying one of the plurality of voltages which is closest to the voltage indicated by the digitised input signal. Where the laser signal comprises a pulsed laser signal, it may be that the analogue-to-digital converter is clocked at a pulse repetition rate of the laser signal. In such cases, it may be that the minimum sampling rate is greater than or equal to the Nyquist requirement of the bandwidth of the input signal voltage.

The method may further comprise obtaining a further laser signal. It may be that obtaining the further laser signal comprises generating the laser signal (for example, by operating a laser). Alternatively, it may be that the further laser signal is received from an external source (for example, separate from the apparatus). It may be that obtaining the further laser signal comprises performing optical splitting of the laser signal. Thus, the further laser signal may be derived from (for example, a further instance of) the laser signal. The further laser signal may therefore be the laser signal (for example, there may be only one unmodulated laser signal).

The method may further comprise modulating, using an electro-optic phase modulator, the further laser signal on the basis of the analogue input signal. It may be that the modulating of the further laser signal is different to the modulating of the laser signal. In such cases, it may be that the further laser signal is modulated to a lesser degree than the laser signal. It may be that the modulating of the further laser signal is such that variation of the analogue input signal imparts on the modulated further laser signal a phase shift of no more than one cycle (for example, relative to the further laser signal). It may be that the electro-optic phase modulator is configured to impart on the further laser signal a third phase shift when the analogue input signal is at the first voltage. It may be that the electro-optic phase modulator is configured to impart on the laser signal a fourth phase shift when the analogue input signal is at the second voltage. In such cases, it may be that the difference between the third phase shift and fourth phase shift is no more than one cycle. Thus, it may be that the modulated laser signal has a third phase when the analogue input signal is at the first voltage and a fourth phase when the analogue input signal is at the second voltage. In such cases, it may be that the third phase and the fourth phase are more than one cycle apart. Thus, it may be that, as the voltage of the analogue input signal increases from the first voltage to the second voltage, the phase of the modulated laser signal increases by no more than one cycle. Thus, it may be that the modulating of the further laser signal is such that any given phase of the modulated further laser signal is associated with only one voltage of the analogue input signal. The determining of the voltage of the analogue input signal may be performed on the basis of the modulated further laser signal.

It may be that the further laser signal is modulated by a separate electro-optic phase modulator to the first laser signal. Thus, it may be that modulating the further laser signal comprises operating a further electro-optic phase modulator. Operating the further electro-optic phase modulator may comprise modifying (for example, attenuating) the analogue input signal. In such cases, it may be that the further electro-optic phase modulator is configured to modulate to a different (for example, lesser) degree than the first electro-optic phase modulator (for example, by virtue of being operated on the basis of an attenuated instance of the analogue input signal).

It may be that the laser signal is modulated only by the electro-optic phase modulator and the further laser signal is modulated only by the further electro-optic phase modulator. In such cases, the electro-optic phase modulator and the further electro-optic phase modulator can be said to be arranged in parallel. Alternatively, it may be that the further laser signal is modulated only by the further electro-optic phase modulator and the laser signal is modulated by both the electro-optic phase modulator and the further electro-optic phase modulator (for example, resulting in greater modulation of the laser signal than the further laser signal). In such cases, the electro-optic phase modulator and the further electro-optic phase modulator can be said to be arranged in series. Thus, it may be that the further laser signal is the further modulated laser signal. It may be that obtaining the laser signal comprises performing optical splitting of the modulated further laser signal. Thus, the laser signal may be derived from (for example, a further instance of) the modulated further laser signal.

It may be that the modulated laser signal and the modulated further laser signal are both produced by the electro-optic phase modulator. Thus, it may be that the method comprises operating only one electro-optic phase modulator (for example, one having two outputs). It may be that the electro-optic phase modulator is configured to apply different degrees of modulation to two separate instances of the laser signal in order to produce the modulated laser signal and the further modulated laser signal. For example, the electro-optic phase modulator may comprise two optical transmission paths following an optical splitter whose refractive index depends on the applied electric field, as will be known to those skilled in the design of optical modulators. In such cases, it may be that an optical splitter shares the laser signal between two paths. Each path is to a greater or lesser extent exposed to the electric field produced by feeding the input voltage onto a common modulating electrode. Those skilled in the design of optical modulators will appreciate that a return electrode or ground plane is also required as a counterpoise to the modulating electrode. The degree of exposure to the electric field determines the sensitivity of the output phase in each path to the input voltage. The degree of exposure to the electric field may be controlled by the proximity of each optical path to the modulating electrode and the length of each optical path which is exposed closely to the electric field.

An alternative instance of the two output modulator may place an optical splitter after a common first stage of modulation, with only the second of the two optical paths further exposed closely to the electric field produced by the input voltage. Thus, only the second instance is further modulated, resulting in a modulated laser signal which is differently modulated to the first modulated laser signal.

Those skilled in the design of optical modulators with a high electrical bandwidth will know that the modulating electrode may form a transmission line that supports the propagation of the electrical signal alongside the optical signals.

It may be that the identifying of the voltage which has caused the assumed phase state of the modulated laser signal is performed on the basis of the modulated further laser signal (for example, based on a measurement of the phase of the modulated further laser signal). It will be appreciated by the skilled person that, where the modulating of the further laser signal phase shifts the modulated further laser signal by no more than one cycle, the modulated further laser signal provides an indication of which of the plurality of voltages has given rise to the phase state of the modulated laser signal. It may be that the modulating of the further laser signal is such that the modulated further laser signal has a further plurality of possible phase states. In such cases, it may be that each of the further plurality of possible phase states is associated with only a respective one of the plurality of possible voltages of the analogue input signal.

It may be that the electro-optic phase modulator is configured to produce both the modulated laser signal and the modulated further laser signal (for example, by modulating the laser signal). In such cases, it may be that the electro-optic phase modulator is configured to perform first modulating of the laser signal to produce the modulated laser signal. The electro-optic phase modulator may be configured to perform second modulating of a further laser signal (which may, for example, be the laser signal) to produce the modulated further laser signal. It may be that the first modulating is different to the second modulating (for example, such that the modulation of the laser signal is greater than that of the further laser signal).

It may be that the electro-optic phase modulator itself comprises first and second electro-optic phase modulators. In such cases, it may be that the first electro-optic phase modulator is configured to produce the modulated further laser signal (for example, by modulating the laser signal). It may be that the second electro-optic phase modulator is configured to produce the modulated laser signal (for example, by modulating the laser signal or by additionally modulating the modulated further laser signal. It may be that the producing of the modulated laser signal is performed by the first and second electro-optic phase modulators together. It may be that the producing of the modulated further laser signal is performed by only one of the first and second electro-optic phase modulators.

It may be that the determining of the voltage of the analogue input signal comprises performing coherent optical detection on the modulated laser signal. Thus, determining of the change in voltage of the analogue input signal may comprise operating a first coherent optical detector (for example, to perform coherent optical detection on the modulated laser signal). It may be that the coherent optical detector comprises an optical quadrature coupler. It may be that the coherent optical detector comprises one or more photodiodes. Thus, it may be that determining of the change in voltage of the analogue input signal comprises operating an optical quadrature hybrid coupler. In embodiments with a further laser signal, it may be that the determining of the change in voltage of the analogue input signal comprises performing coherent optical detection on the modulated further laser signal. Thus, determining of the change in voltage of the analogue input signal may comprise operating a second coherent optical detector (for example, to perform coherent optical detection on the modulated further laser signal).

It will be appreciated by the skilled person that a coherent optical detector generates two analogue electrical signals associated with the in-phase and quadrature signal components of the input signal. Thus, performing coherent optical detection on the modulated laser signal may comprise generating an in-phase analogue electrical signal associated with the in-phase component (for example, with respect to the laser reference) of the modulated laser signal. Performing coherent optical detection on the modulated laser signal may comprise generating a quadrature analogue electrical signal associated with the quadrature component (for example, with respect to the laser reference) of the modulated laser signal. Similarly, performing coherent optical detection on the modulated further laser signal may comprise generating a further in-phase analogue electrical signal associated with the in-phase component of the modulated further laser signal. Performing coherent optical detection on the modulated further laser signal may comprise generating a further quadrature analogue electrical signal associated with the quadrature component of the modulated laser signal.

The method may comprise performing analogue-to-digital conversion of the in-phase analogue electrical signal and the quadrature analogue electrical signal. Thus, the method may comprise operating first and second analogue to digital converters to perform analogue-to-digital conversion of the in-phase analogue electrical signal and the quadrature analogue electrical signal. In such cases, the first and second analogue-to-digital converters may have a bandwidth of at least the bandwidth of the analogue input signal multiplied by the number of folds. In embodiments having a further laser signal, the method may comprise performing analogue-to-digital conversion of the further in-phase analogue electrical signal and the further quadrature analogue electrical signal. Thus, the method may comprise operating third and fourth analogue to digital converters to perform analogue-to-digital conversion of the further in-phase analogue electrical signal and the further quadrature analogue electrical signal. As mentioned above, the bandwidths of ADCs are generally significantly less limited than their dynamic ranges, Thus, the pre-processing of the analogue input signal transposes the information originally embodied in the varying voltage of the analogue input signal (which the ADCs are less suited to measuring, due to their limited dynamic range) onto the phase of the modulated laser signal (which the ADCs are more suited to measuring, due to their relatively high bandwidths).

It will be appreciated by the skilled person that coherent optical detection of a signal allows recovery of the within cycle phase of that signal. Thus, the coherent optical detection can be considered to be a form of within cycle phase detection. Thus, the method may further comprise determining a change in phase (for example, within cycle phase) of the modulated laser signal. In such cases, it may be that the determining of the change in voltage of the analogue input signal is performed on the basis of the determined change in phase (for example, the determined within cycle phase). It may be that determining the change in phase of the modulated laser signal comprises measuring a phase difference between the modulated laser signal and the laser signal. In such cases, it may be that the measured phase difference is no more than one cycle. That is to say, it may be that the measured phase difference is no more than +π and no less than -π.

The method may further comprise determining a further change in phase of the modulated further laser signal. In such cases, it may be that the determining of the change in voltage of the analogue input signal is performed on the basis of the determined further change in phase.

According to a second aspect of the invention there is also provided an apparatus for performing analogue to digital conversion of an analogue input signal, the apparatus comprising:
an electro-optic phase modulator configured to receive a laser signal and modulate the laser signal on the basis of the analogue input signal; and
a processor configured to determine, on the basis of the modulated laser signal, a change in voltage of the analogue input signal and generate a digital signal indicative of the determined voltage.

It will of course be appreciated that features described in relation to one aspect of the present invention may be incorporated into other aspects of the present invention. For example, the method of the invention may incorporate any of the features described with reference to the apparatus of the invention and vice versa.

### BRIEF DESCRIPTION OF THE FIGURES

Embodiments of the invention will now be described by way of example only with reference to the figures, in which:
Figure 1 shows a schematic view of an apparatus according to a first embodiment of the invention;
Figure 2 shows a graph illustrating the relationship between input voltage and output within cycle phase of the electro-optic phase modulator of Figure 1;
Figure 3 shows a schematic view of an apparatus according to a second embodiment of the invention;
Figure 4 shows a schematic view of an apparatus according to a third embodiment of the invention;
Figure 5 shows a schematic view of an apparatus according to a fourth embodiment of the invention; and
Figure 6 shows a flow chart illustrating the steps of a method according to a fifth embodiment of the invention.

### DETAILED DESCRIPTION

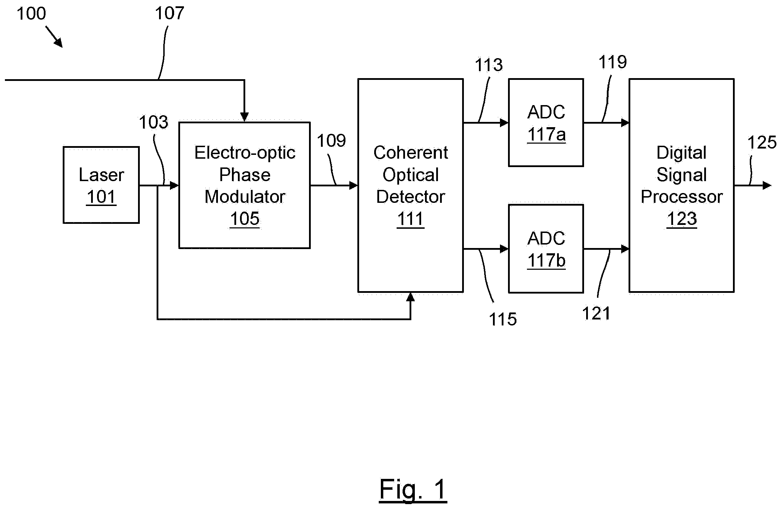

Figure 1 shows a schematic view of an apparatus 100 according to a first embodiment of the invention.

In this example embodiment, the apparatus 100 comprises a laser 101. The laser 101 is configured to generate a laser signal 103. In this example embodiment, the laser 101 comprises a continuous wave laser. Thus, in this example embodiment, the laser signal 103 comprises a continuous wave laser signal. However, it will be appreciated by the skilled person that, in other embodiments, the laser 101 may comprise a pulsed laser (and the laser signal 103 may therefore comprise a pulsed laser signal) or any other suitable laser. It will also be appreciated by the skilled person that, in other embodiments, the laser signal 103 may be received at the apparatus 100 from an external source. Such an external source may, for example, be located apart from the apparatus and connected to the apparatus by optic fibre.

The laser signal 103 is input to an electro-optic phase modulator 105. In this example embodiment, the electro-optic phase modulator 105 operates by use of the Pockels effect. Thus, the electro-optic phase modulator 105 operates by varying the refractive index of a medium through which the laser signal 103 passes. Varying the refractive index of the medium varies the velocity of the laser signal 103 through the medium, in turn varying the time taken for the laser signal 103 to pass through the medium and thereby the phase of the modulated laser signal 109 at the point at which it exits the electro-optic phase modulator 105. Thus, the electro-optic phase modulator 105 operates to phase modulate the laser signal 103. It will be appreciated by the skilled person that other types of electro-optic phase modulator may alternatively be used.

The electro-optic phase modulator 105 is configured to phase modulate the laser signal 103 on the basis of a voltage of an analogue input signal 107 to produce a modulated laser signal 109. The analogue input signal 107 comprises an analogue electrical signal having a voltage that varies between a first voltage and a second voltage. Thus, the analogue input signal can be said to have a predetermined voltage range (i.e. the difference in voltage between the first voltage and the second voltage), within which the voltage of the analogue input signal varies. The electro-optic phase modulator 105 operates to convert the variation in the voltage of the analogue input signal 107 into a corresponding phase variation in the modulated laser signal 109.

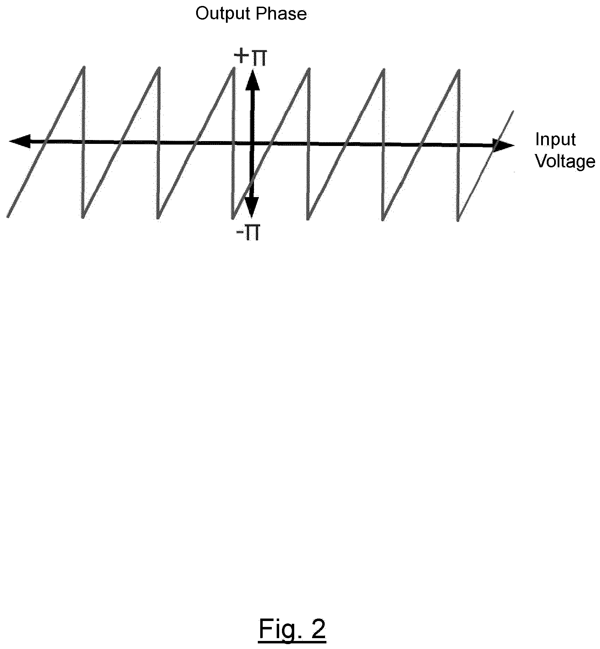

The electro-optic phase modulator 105 is configured to phase modulate the laser signal 103 phase according to the voltage of the analogue input signal. Figure 2 shows a graph illustrating the relationship between the voltage of the analogue input signal 107 and the output within cycle phase of the modulated laser signal 109. The within cycle phase of modulated laser signal 109 varies as a sawtooth waveform as the voltage of the analogue input signal 107 increases.

The electro-optic phase modulator 105 is configured to modulate the laser signal 103 such that variation of the analogue input signal 107 imparts on the laser signal 103 a phase shift of greater than one cycle. Thus, as the voltage of the analogue input signal 107 increases from the first voltage to the second voltage, the phase of the modulated laser signal 109 progresses through more than one cycle. The electro-optic phase modulator 105 is therefore configured to impart on the laser signal 103 a first phase shift when the analogue input signal 107 is at the first voltage. Similarly, the electro-optic phase modulator 105 is configured to impart on the laser signal 103 a second phase shift when the analogue input signal 107 is at the second voltage. In this example, the difference between the first and second phase shifts is more than one cycle. In this example, the electro-optic phase modulator 105 is configured such that variation of the analogue input signal 107 causes the phase of the modulated laser signal 109 to vary through ten complete cycles. It will be appreciated by the skilled person that, in other embodiments, the electro-optic phase modulator 105 may be configured such that variation of the analogue input signal 107 causes the phase of the modulated laser signal 109 to vary by a greater or fewer number of cycles.

It will be appreciated by the skilled person that each of the possible phases of the modulated laser signal 109 can be considered to be a phase state of the modulated laser signal 109. Thus, the modulated laser signal 109 can be said to have a plurality of possible phase states. The electro-optic phase modulator 105 is configured to cause the modulated laser signal to assume one of the plurality of possible phase states. Which of the plurality of possible phase states is assumed depends on the voltage of the analogue input signal 107. Thus, the assumed phase state is associated with the voltage of the analogue input signal 107.

It will be appreciated by the skilled person that, because the electro-optic phase modulator 105 is configured such that variation of the analogue input signal 107 causes the modulated laser signal 109 to vary through a plurality (in this example, ten) complete cycles, each possible phase of the modulated laser signal 109 is associated with a plurality of different voltages of the analogue input signal 107. The number of different voltages of the analogue input signal 107 associated with a given within cycle phase of the modulated laser signal 109 will in most cases be equal to the number of folds. It will be appreciated by the skilled person that this might not be precisely the case where the electro-optic phase modulator 105 is configured such that variation of the analogue input signal 107 causes the modulated laser signal 109 to vary through a nonunitary number of cycles. Thus, each of the plurality of possible phase states is associated with a plurality of possible voltages of the analogue input signal 107.

The modulated laser signal 109 is input into a coherent optical detector 111. The coherent optical detector 111 operates to perform coherent optical detection of the modulated laser signal 109. Thus, the coherent optical detector 111 operates to determine the within cycle phase of the analogue input signal 107. To that end, apparatus 100 also includes a reference connection of the laser signal 103 from the laser 101 to the coherent optical detector 111 (for example, to enable a phase shift between the modulated laser signal 109 and the laser signal 103 to be determined). Coherent optical detection is well-known to the skilled person and will not be discussed in further detail here. The coherent optical detector 111 is configured to generate two analogue electrical output signals: an in-phase (I) analogue electrical signal 113 and a quadrature (Q) analogue electrical signal 115. The amplitudes of the I and Q signals are substantially constant and do not depend on the voltage of the analogue input signal 107. The frequency content and relative phase of the I and Q signals are affected by the voltage of the analogue input signal 107.

The in-phase analogue electrical signal 113 and the quadrature analogue electrical signal 115 are each input into a respective analogue to digital converter (ADC) 117a, 117b. The ADCs 117a, 117b operate to convert the two signals 113, 115 into respective digital bitstreams. Thus, ADC 117a is configured to convert in-phase analogue electrical signal 113 into an in-phase bitstream 119. ADC 117b is configured to convert the quadrature analogue electrical signal 115 into a quadrature bitstream 121. In this example, the ADCs 117a, 117b each have a bandwidth that is more than ten (i.e. the number of folds) times the bandwidth of the analogue input signal 107 in order to accommodate the bandwidth multiplication that occurs due to the folding operation.

The in-phase bitstream 119 and the quadrature bitstream 121 are each input into an digital signal processor 123. The digital signal processor 123 is configured to determine, on the basis of the in-phase bitstream 119 and the quadrature bitstream 121, the change in voltage of the analogue input signal 107 since the most recent sample. The skilled person will appreciate that it is possible to determine the within cycle phase of the modulated laser signal 109 (for example, by use of trigonometry) from the in-phase analogue electrical signal 113 and the quadrature analogue electrical signal 115 (both of which are characterised by the in-phase bitstream 119 and quadrature bitstream 121). Thus, the digital signal processor 123 can determine the change in phase of the modulated laser signal 109 since the most recent sample, and therefore also the assumed phase state of the modulated laser signal 109. The digital signal processor 123 is configured to determine and evaluate the assumed phase state to determine the change in voltage of the analogue input signal 107. Thus, the coherent optical detector 111 and the digital signal processor 123 together act as a phase detector. The phase detector has a cyclic response, so is only able to identify the relative phase between the modulated laser signal 109 and the laser signal 103 to within a single cycle. Whilst in this example embodiment phase detection is provided by use of a coherent optical detector, it will be appreciated by the skilled person that, in other embodiments, other methods of phase detection may alternatively be used.

As previously mentioned, because the electro-optic phase modulator 105 is configured such that variation of the analogue input signal 107 causes the modulated laser signal 109 to vary through ten complete cycles, each possible phase of the modulated laser signal 109 is associated with a plurality (in this example, ten) of different voltages of the analogue input signal 107. The digital signal processor 123 is configured to identify which voltage in the plurality of possible voltages has caused the assumed phase state. In this example embodiment, the voltage of the analogue input signal 107 is known to vary relatively slowly (having a bandwidth of less than one tenth of the bandwidth of the ADCs 117a, 117b). Thus, as the voltage of the analogue input signal 107 varies, the assumed phase state can be tracked as it progresses between adjacent folds. In this example, the analogue input signal 107 has a known voltage on start-up of the apparatus 100. Thus, the assumed phase state can be tracked as it varies from the one associated with the initial known voltage (in this example, by accumulating the phase differences between consecutive samples to reconstruct the variation of the voltage of the analogue input signal 107), allowing the digital signal processor 123 to identify subsequent voltages. Because of the slowly varying voltage of the analogue input signal 107 in this example, the digital signal processor 123 can identify the voltage on the basis of one or more previously determined voltages of the analogue input signal 107. In particular, the digital signal processor 123 is configured to identify the voltage by selecting a nearest one of the plurality of possible voltages to a most recently determined voltage of the analogue input signal 107.

The digital signal processor 123 is further configured to generate a digital signal 125 indicative of the determined voltage. It will be appreciated by the skilled person that, in other embodiments, the digital signal processor 123 may be configured to also perform one or more other functions. For example, the digital signal processor 123 may be configured to perform one or more of quadrature error correction and demodulation.

It will be appreciated by the skilled person that other means for identifying the which voltage in the plurality of possible voltages has caused the assumed phase state can alternatively be used, for example as described in respect of the following embodiments of the invention.

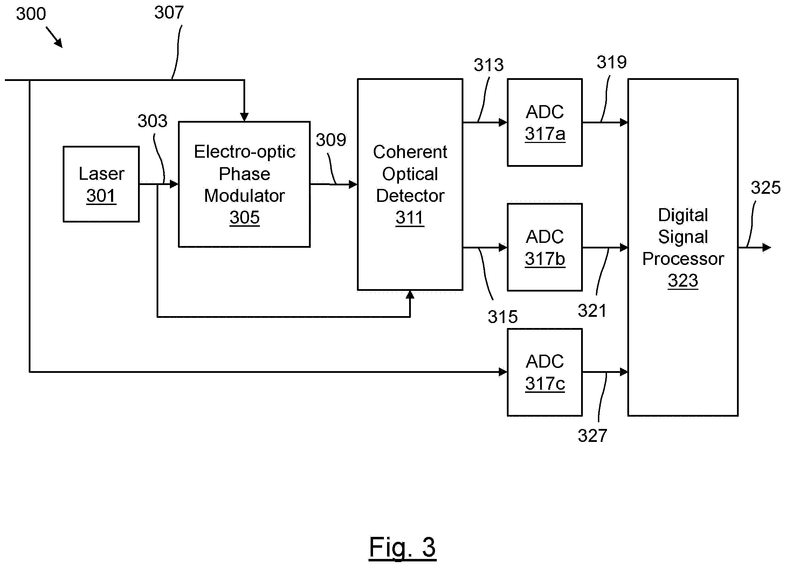

Figure 3 shows a schematic view of an apparatus 300 according to a second embodiment of the invention. Apparatus 300 is substantially as described above in respect of apparatus 100 of the first embodiment but for the following differences.

In this embodiment, the laser signal 303 comprises a pulsed laser signal. The pulse width of the laser signal 303 is, in this example embodiment, less than one half period of the product of the highest input signal frequency and the frequency multiplication resulting from the folding operation (i.e. the number of folds). The pulse width of the laser signal 303 at the electro-optic modulator 305 defines the sampling aperture of the apparatus 300. In this example, the modulated laser signal 309 and the laser signal 303 input to the coherent optical detector 311 are synchronised, such that a pulse of the modulated laser signal 309 and a corresponding pulse of the laser signal 301 reach the coherent optical detector 311 with a significant overlap in time (for example, of at least 50%).

Because the laser signal 303 comprises a pulsed laser signal, the in-phase analogue electrical signal 313 and the quadrature analogue electrical signal 315 are also pulsed signals, but their pulses are shaped by the electrical impulse response of the coherent optical detector 311. In this example embodiment, the I and Q electrical signals are low-pass filtered to produce I and Q electrical pulses which are wider than the optical pulse input to the coherent optical detector 311 and therefore easier for the ADCs 317a, 317b to sample. It will be appreciated by the skilled person that, in other embodiments, other means may also be used to prolong the I and Q electrical signals to facilitate sampling by the ADCs 317a, 317b. For example in other embodiments, the apparatus may be configured to, alternatively or additionally to low-pass filtering, perform pulse extension or repetition (for example, by incorporating an optical pulse stretcher such as an etalon in each of the I and Q optical signals prior to photo-detection) to facilitate sampling by the ADCs 317a, 317b.

In this example embodiment, the ADCs 317a, 317b are configured to sample at the same rate with a suitable delay such that pulsed detector output coincides with the sampling interval of the ADCs.

The apparatus 300 further comprises a third ADC 317c. The third ADC 317c is configured to receive the analogue input signal and digitise it to produce a digitised input signal 327 indicative of a voltage of the analogue input signal. It will be appreciated by the skilled person that, like all ADCs, the third ADC 317c will have limitations on the range of input voltages it can accept, and therefore the analogue input signal 307 must be scaled (for example, attenuated) to fit those limitations. Thus, the apparatus 300 may also comprise one or more voltage scaling circuits (for example, potential dividers) configured to scale the analogue input signal 307 prior to it being input into the third ADC 317c. The measurement of the voltage of the analogue input signal 307 provided by the third ADC 317c may therefore be relatively imprecise. The digitised input signal 327 can therefore be considered to provide a coarse measurement of the voltage of the analogue input signal 307.

The digital signal processor 323 is configured to receive the digitised input signal 327 and identify which of the plurality of possible voltages has given rise to the assumed phase state on the basis of the digitised input signal 327. Whilst the measurement of the voltage of the analogue input signal 307 provided by the third ADC 317c may be relatively imprecise, it will be appreciated by the skilled person that it need only be sufficiently precise to enable the digital signal processor 323 to distinguish between the plurality of possible voltages (i.e. to distinguish between the folds in the electro-optic phase modulator 305 output). Thus, the digital signal processor 323 uses the coarse measurement of the voltage of the analogue input signal 307 to identify which of the plurality of possible voltages is correct. The identified voltage enables a precise measurement of the change in voltage of the analogue input signal 307.

The skilled person will appreciate that the apparatus 300 can be used in circumstances where the voltage of the analogue input signal 207 varies too quickly to allow for which of the possible voltages has caused the assumed phase state to be determined based on previously determined voltages (for example, where the change in phase of the modulated laser signal between consecutive samples can be more than one fold). Thus, the apparatus 300 is effective even where the ADCs 317a, 317b do not have a bandwidth in excess of the product of the bandwidth of the analogue input signal and the number of folds. The apparatus 300 can also be used when the analogue input signal 307 does not have a known value on start-up.

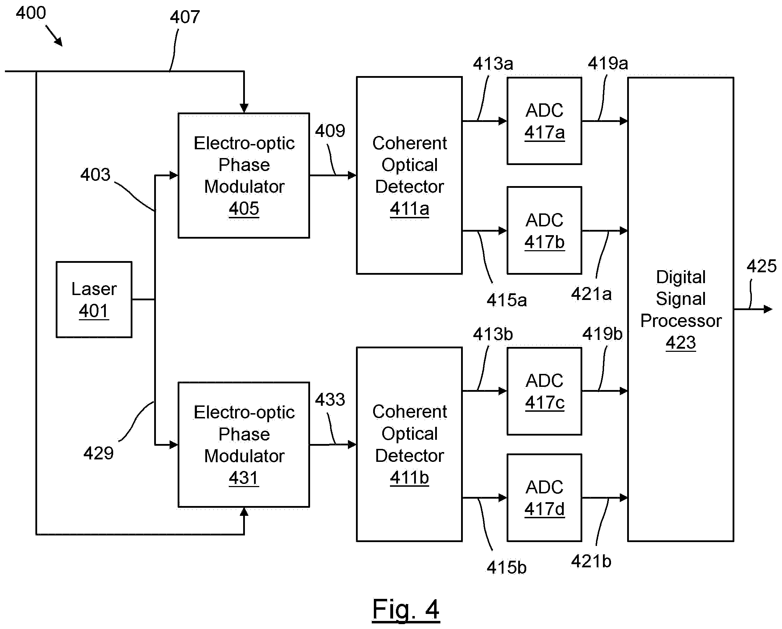

Figure 4 shows a schematic view of an apparatus 400 according to a third embodiment of the invention. Apparatus 400 is substantially as described above in respect of apparatus 100 of the first embodiment but for the following differences.

As in the case of the first embodiment, the apparatus 400 comprises a laser 401, an electro-optic phase modulator 405, a coherent optical detector 411a, and first and second ADCs 417a, 417b.

In this example embodiment, the laser 401 comprises a pulsed laser, and thus laser signal 403 comprises a pulsed laser signal.

The apparatus 400 comprises an optical splitter (not shown) configured to receive the laser signal 403 and perform optical splitting to produce two instances of the laser signal 403. Thus, the optical splitter can be said to generate a further laser signal 429. The laser signal 403 is input into the coherent optical detector 411a. The coherent optical detector 411a, and first and second ADCs 417a, 417b operate as described above in respect of the apparatus 100 of the first embodiment to produce a first in-phase bitstream 419a and a first quadrature bitstream 421a.

In this embodiment, the apparatus 400 comprises a further electro-optic phase modulator 431. The further laser signal 429 is input into the further electro-optic modulator 431. The further electro-optic phase modulator 431 is configured to modulate the further laser signal 429 on the basis of the analogue input signal 407. Thus, the further electro-optic phase modulator 431 is configured to apply a further phase shift to the further laser signal 429 to produce a modulated further laser signal 433. In this example embodiment, the further electro-optic phase modulator 431 is configured to modulate the further laser signal 429 to a lesser degree than the electro-optic phase modulator 405 does the laser signal 403. Thus, for any given voltage of the analogue input signal 407, the further electro-optic phase modulator 431 is configured to apply a smaller phase shift to the further laser signal 429 than the electro-optic phase modulator 405 does to the laser signal 403. In this example, the further electro-optic phase modulator 431 is configured to modulate the further laser signal 429 such that variation of the analogue input signal 407 imparts on the modulated further laser signal 433 a phase shift of no more than one cycle (relative to the further laser signal). Thus, the further electro-optic phase modulator 431 is configured such that any given phase of the modulated further laser signal 433 is associated with only one voltage of the analogue input signal 407.

The modulated further laser signal 433 can also be said to have a plurality of possible phase states. As in the case of the first and second embodiments, which of the plurality of possible phase states of the modulated further laser signal 433 is assumed depends on the voltage of the analogue input signal 407. Thus, both the modulated laser signal 409 and the modulated further laser signal 433 will assume respective phase states, each associated with the voltage of the analogue input signal 407. It will be appreciated by the skilled person that, due to the differing modulation of the modulated further laser signal 433 to that of the modulated laser signal 409, the phase state assumed by the modulated further laser signal 433 will differ from that assumed by the modulated laser signal 409. As the further electro-optic phase modulator 431 is configured to phase shift the modulated further laser signal 433 by no more than one cycle, each possible phase state of the modulated further laser signal 433 is associated with only one voltage of the analogue input signal 407.

The apparatus 400 comprises a further coherent optical detector 411b, and third and fourth ADCs 417c, 417d. The further coherent optical detector 411b, and third and fourth ADCs 417c, 417d operate in the same way as the coherent optical detector 411a, and first and second ADCs 417a to produce a second in-phase bitstream 419b and a second quadrature bitstream 421b. Thus, the modulated further laser signal 433 is input into the coherent optical detector 411b, which is configured to perform coherent optical detection of the modulated further laser signal 433.

The digital signal processor 423 is configured to determine, on the basis of the first in-phase bitstream 419a, the second phase bitstream 419b, the first quadrature bitstream 421a, and the second quadrature bitstream 421b, the voltage of the analogue input signal 407. As previously described, it is possible to determine the phase of the modulated laser signal 409 from the first in-phase bitstream 419a and the first quadrature bitstream 421a. Similarly, it is possible to determine the phase of the further modulated laser signal 431 from the second in-phase bitstream 419b and the second quadrature bitstream 421b. Thus, the digital signal processor 423 can determine the assumed phase states of the modulated laser signal 409 and the modulated further laser signal 433. The digital signal processor 423 is configured to determine and evaluate the assumed phase states to determine the voltage of the analogue input signal 407.

In some example embodiments, the digital signal processor 423 may be configured to determine the change in voltage of the analogue input signal 407 by performing the following steps: (1) take the latest coarse phase estimate and subtract from it the previous coarse phase estimate to estimate the "coarse" phase change in the precise output between a current and preceding sample; (2) take the latest precise phase estimate and subtract the previous precise phase estimate, to calculate the "fine" phase change in the precise output between the current and preceding samples; (3) resolve the coarse and fine estimates such that the true phase change in the precise output between the current and preceding samples can be estimated with the accuracy and sensitivity of the precise output; and (4) translate the changes in phase to changes in the voltage of the input signal.

As described above in respect of the first and second embodiments, the phase of the modulated laser signal 409 indicates a plurality of possible voltages of the analogue input signal 107. The phase of the modulated further laser signal 433 in this example indicates a coarse measurement of the voltage of the analogue input signal 407 (similarly to as described above in respect of the second embodiment). The digital signal processor 423 is configured to use the coarse measurement provided by the modulated further laser signal 433 to identify which of the plurality of possible voltages of the analogue input signal 407 has given rise to the phase state of the modulated laser signal 409. Thus, the identification of which of the plurality of possible voltages has given rise to the assumed phase state of the modulated laser signal 409 is performed on the basis of the modulated further laser signal 433. The digital signal processor 423 thereby determines a precise measurement of the voltage of the analogue input signal 407.

Using the same components to capture both the coarse and precise measurement of the voltage of the analogue input signal 407 ensures that the coarse and precise measurements are subject to substantially equal timing delays. Observing both the coarse and precise measurements of the voltage of the analogue input signal 407 simultaneously also allows the use of a reduced ADC sample rate (for example, only at the Nyquist rate required to capture the largest frequency component of the analogue input signal).

To improve readability, the reference connections of the laser 401 to the coherent optical detectors 411a, 411b have been omitted. It will be appreciated by the skilled person that such reference connections are still present in this embodiment.

The path length delays between the laser signal that becomes modulated and the laser reference are closely matched such that pulses from both sources arrive coincidentally at the coherent phase detector(s) and that the effect of laser phase noise is minimised.

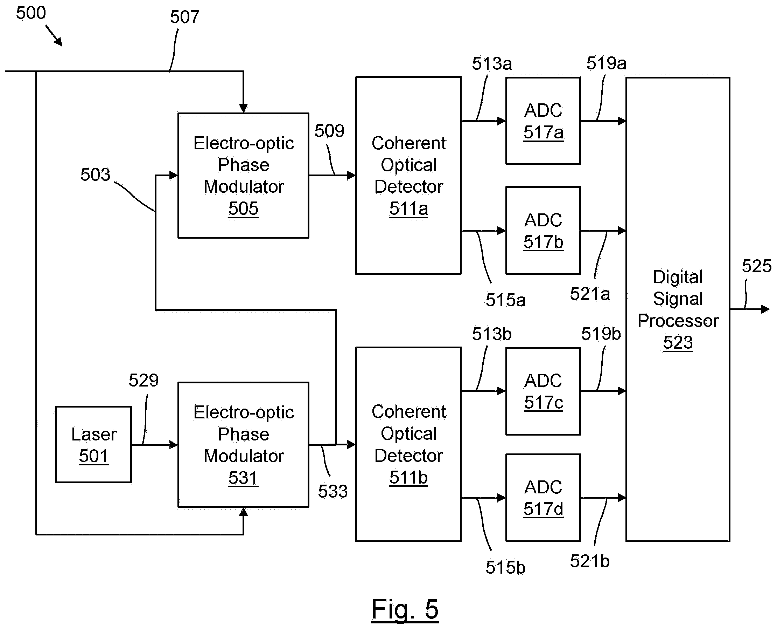

Figure 5 shows a schematic view of an apparatus 500 according to a fourth embodiment of the invention. Apparatus 500 is substantially as described above in respect of apparatus 400 of the third embodiment but for the following differences.

In this example embodiment, the further laser signal 529 is input into the further electro-optic phase modulator 531 as in the third embodiment. However, in this example embodiment, the modulated further laser signal 533 which, as in the case of the third embodiment is only lightly modulated, is input into the electro-optic phase modulator 505. Thus, the apparatus 500 also comprises an optical splitter (not shown). However, in this example embodiment, the optical splitter is configured to receive the modulated further laser signal 533 and perform optical splitting to produce two instances of the modulated further laser signal 533. Thus, in this example embodiment, the second instance of the modulated further laser signal 533 can be considered to be the laser signal 503.

The electro-optic phase modulator 505 is configured to further modulate the laser signal 503 (which has, as discussed above, already been modulated to a certain extent). Thus, in this embodiment, the electro-optic phase modulator 405 is configured to perform only part of the desired phase modulation (for example, in order to achieve a desired number of folds). Thus, the electro-optic phase modulator 405 can be said to be configured to "top-up" the modulation of the laser signal 403 (for example, to achieve a desired number of folds). Thus, in this example embodiment, the modulation of the modulated laser signal 409 is provided by the electro-optic phase modulator 505 and the further electro-optic phase modulator 531 together.

To improve readability, the reference connections of the laser 501 to the coherent optical detectors 511a, 511b have been omitted. It will be appreciated by the skilled person that such reference connections are still present in this embodiment.

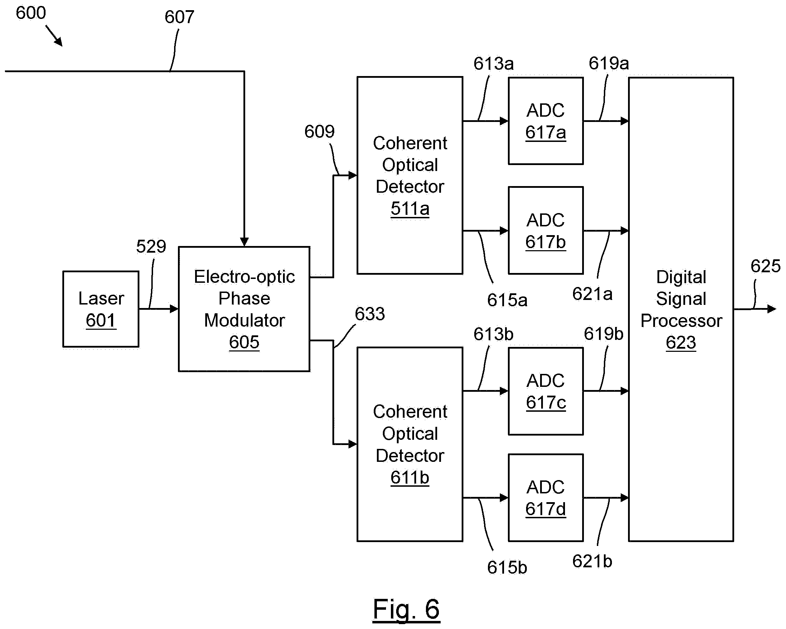

Figure 6 shows a schematic view of an apparatus 600 according to a fifth embodiment of the invention. Apparatus 600 is substantially as described above in respect of apparatus 500 of the fourth embodiment but for the following differences.

Apparatus 600 comprises only a single electro-optic phase modulator 605. In this embodiment, electro-optic phase modulator 505 and the further electro-optic phase modulator 531 are effectively combined into a signal component. In this embodiment, the electro-optic phase modulator 605 is configured to generate both the modulated laser signal 609 and the modulated further laser signal 633. In this example, the electro-optic phase modulator 605 comprises an optical transmission path formed of a material which is sensitive to electric fields and an optical splitter. The electro-optic phase modulator 605 is arranged to modulate the further laser signal 631 by applying an electric field across a first portion of the optical transmission path, creating the modulated further laser signal 633. The optical splitter is arranged to perform optical splitting of the modulated further laser signal 633, creating two instances of the modulated further laser signal 633. A first instance is output from the electro-optic phase modulator 605, whilst the second instance is further modulated. The further modulating is performed by applying a further electric field across a second portion of the optical transmission path used by only the second instance of the modulated further laser signal 633. Thus, only the second instance is subjected to the additional modulation, resulting in a modulated laser signal 609 which is differently modulated to (in this example, more strongly modulated than) the modulated further laser signal 633. Thus, as in the fourth embodiment, the second instance of the modulated laser signal 633 can be considered to be the laser signal.

To improve readability, the reference connections of the laser 601 to the coherent optical detectors 611a, 611b have been omitted. It will be appreciated by the skilled person that such reference connections are still present in this embodiment.

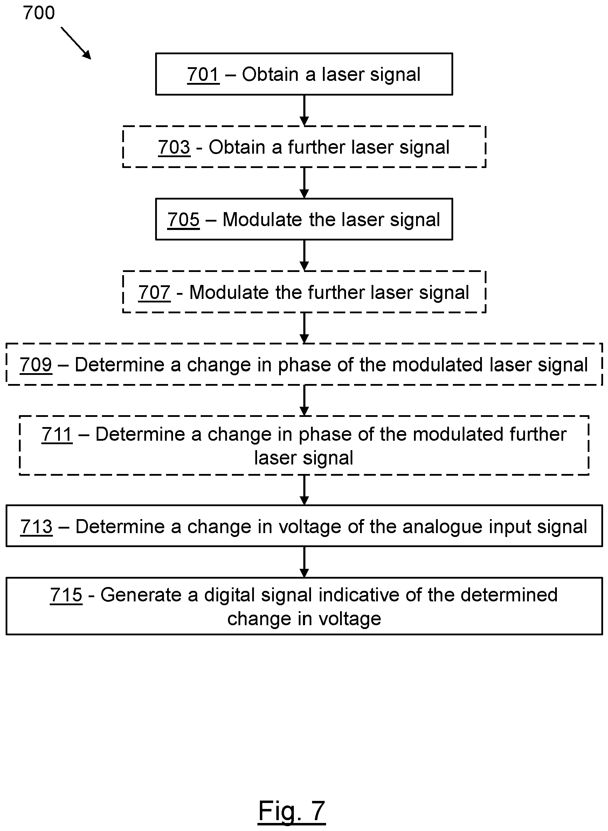

Figure 7 shows a flow chart illustrating the steps of a method 700 of performing analogue to digital conversion of an analogue input signal according to a fifth embodiment of the invention.

A first step of the method 700, represented by item 701, comprises obtaining a laser signal. The laser signal may comprise a pulsed laser signal. It may be that obtaining the laser signal comprises generating the laser signal (for example, by operating a laser).

An optional second step of the method 700, represented by item 703, comprises obtaining a further laser signal. It may be that obtaining the further laser signal comprises generating the further laser signal. It may be that generating the further laser signal comprises performing optical splitting of the first laser signal.

A third step of the method 700, represented by item 705, comprises modulating, using an electro-optic phase modulator, the laser signal on the basis of the analogue input signal.

It may be that the modulating is such that variation of the analogue input signal imparts on the laser signal a phase shift of greater than one cycle. It may be that the modulating is such that a within cycle phase of the modulated laser signal varies substantially periodically as a voltage of the analogue input signal increases. It may be that the modulating is such that variation of the analogue input signal causes the within cycle phase of the modulated laser signal to vary through multiple complete cycles. It may be that the modulated laser signal has a plurality of possible phase states. In such cases, it may be that the modulating comprises causing the modulated laser signal to assume one of the plurality of possible phase states. The assumed phase state may be associated with the voltage of the analogue input signal. It may be that at least one of the plurality of possible phase states is associated with a plurality of possible voltages of the analogue input signal.

An optional fourth step of the method 700, represented by item 707, comprises modulating, using an electro-optic phase modulator, the further laser signal on the basis of the analogue input signal. It may be that the modulating of the further laser signal is different to the modulating of the first laser signal.

The modulating of the further laser signal may be such that the modulated further laser signal has a further plurality of possible phase states. In such cases, it may be that each of the further plurality of possible phase states is associated with only a respective one of the plurality of possible voltages of the analogue input signal.

An optional fifth step of the method 700, represented by item 709, comprises determining a change in phase of the modulated laser signal.

An optional sixth step of the method 700, represented by item 711, comprises determining a change in phase of the modulated further laser signal.

A seventh step of the method 700, represented by item 713, comprises determining, on the basis of the modulated laser signal, a change in voltage of the analogue input signal. It may be that the determining of the change in voltage of the analogue input signal is performed on the basis of the determined change in phase of the modulated laser signal.

It may be that the determining comprises evaluating the assumed phase state. The determining may comprise identifying which voltage in the plurality of possible voltages has caused the assumed phase state. In such cases, the identifying may be performed on the basis of one or more previously determined voltages of the analogue input signal. It may be that the method further comprises operating an analogue to digital converter to convert the analogue input signal into a digitised input signal. In such cases, the identifying may be performed on the basis of the digitised input signal. In embodiments in which the method 700 comprises generating and modulating a further laser signal, it may be that the determining is performed further on the basis of the modulated further laser signal. In such cases, it may be that the identifying is performed on the basis of the modulated further laser signal. The determining may comprise performing coherent optical detection on the modulated laser signal.

An eighth step of the method 700, represented by item 715, comprises generating a digital signal indicative of the determined voltage.

Whilst the present invention has been described and illustrated with reference to particular embodiments, it will be appreciated by those of ordinary skill in the art that the invention lends itself to many different variations not specifically illustrated herein. By way of example only, certain possible variations will now be described.

Whilst each of the illustrated embodiments comprise a laser which is used to generate a laser signal. It will be appreciated by the skilled person that, in other embodiments, one or both of the laser signal and the further laser signal may be received at the apparatus from an external source. In such cases, it may be that the external source may be located apart from the apparatus. The external source may be connected to the apparatus by optic fibre (for example, to transmit the laser signal from the external source to the apparatus).

Whilst in the embodiments described above the electro-optic phase modulator is configured such that variation of the analogue input signal causes the phase of the modulated laser signal to vary through ten complete cycles. It will be appreciated by the skilled person that, in other embodiments, the electro-optic phase modulator may be configured such that variation of the analogue input signal causes the phase of the modulated laser signal to vary by a greater or fewer number of cycles.

Whilst in the first embodiment described above the laser comprises a continuous wave laser (and the laser signal comprises a continuous wave laser signal), the apparatus of the first embodiment may alternatively comprise a pulsed laser (and the laser signal may therefore comprises a pulsed laser signal), In such cases, it may be that the pulse width of the laser signal less than one half period of the product of the highest input signal frequency and the frequency multiplication resulting from the folding operation (i.e. the number of folds). It may be that the modulated laser signal and the laser signal input to the coherent optical detector are synchronised, such that a pulse of the modulated laser signal and a corresponding pulse of the laser signal reach the coherent optical detector with a significant overlap in time (for example, of at least 50%).

Whilst in the third, fourth, and fifth embodiments described above the further modulated laser signal is modulated such that variation in the voltage of the analogue input signal gives a phase shift of no more than one cycle, in other embodiments further modulated laser signal may be modulated such that a greater phase shift is applied. In such a case, it may be that the modulating of the laser signal and further laser signal is such that only certain combinations of phase states of the modulated laser signal and the modulated further laser state are valid. Thus, it may be that each valid combination of the phase state of the modulated laser signal and the modulated further laser signal is associated with only one voltage of the analogue input signal. Thus, in such a case, the digital signal processor may be configured to determine the change in voltage of the analogue input signal by evaluating the phase states of the modulated laser signal and the modulated further laser signal (for example, by use of a look-up table).

It will be appreciated by the skilled person that it may be necessary to include calibration means in some embodiments of the invention to enable adjustment of path delays within the apparatus. For example, where the laser signal is a pulsed laser signal, it may be that one or more adjustable delay elements are used to ensure that the pulses arrive at the coherent detector(s) at substantially the same time (or having a minimum desired overlap). The skilled person will also appreciate that such calibration means, and the use of those calibration means, are well-known in the art and will not be further discussed here.

It will be appreciated that the digital signal processor 123, 323, 423, 523, 623 may comprise one or more processors and/or memory. The processor and associated memory may be configured to perform one or more of the above-described functions of the digital signal processor 123, 323, 423, 523, 623. One or more aspects of the embodiments described herein comprise processes performed by apparatus. In some examples, the apparatus comprises one or more processors configured to carry out these processes. In this regard, embodiments may be implemented at least in part by computer software stored in (non-transitory) memory and executable by the processor, or by hardware, or by a combination of tangibly stored software and hardware (and tangibly stored firmware). The techniques described herein may be implemented, at least in part, in software (for example, by a combination of software and hardware). They may include configuring an apparatus to carry out and/or support any or all of techniques described herein.

The one or more processors of the digital signal processor 123, 323, 423, 523, 623 may comprise a central processing unit (CPU). The one or more processors may comprise a graphics processing unit (GPU). The one or more processors may comprise one or more of a field programmable gate array (FPGA), a programmable logic device (PLD), or a complex programmable logic device (CPLD). The one or more processors may comprise an application specific integrated circuit (ASIC). It will be appreciated by the skilled person that many other types of device, in addition to the examples provided, may be used to provide the one or more processors. The one or more processors may comprise multiple co-located processors or multiple disparately located processors. Operations performed by the one or more processors may be carried out by one or more of hardware, firmware, and software.

The one or more processors may comprise data storage. The data storage may comprise one or both of volatile and non-volatile memory. The data storage may comprise one or more of random access memory (RAM), read-only memory (ROM), a magnetic or optical disk and disk drive, or a solid-state drive (SSD). It will be appreciated by the skilled person that many other types of memory, in addition to the examples provided, may also be used. It will be appreciated by a person skilled in the art that the one or more processors may each comprise more, fewer and/or different components from those described.

## Claims

1. A method (700) of performing analogue to digital conversion of an analogue input signal, the method comprising:
obtaining (701) a laser signal;
modulating (705), using an electro-optic phase modulator, the laser signal on the basis of the analogue input signal;
determining (713), on the basis of the modulated laser signal, a change in voltage of the analogue input signal; and
generating (715) a digital signal indicative of the determined voltage.

2. A method according to claim 1, wherein the modulating is such that variation of the analogue input signal over its range imparts on the laser signal a phase shift of greater than one cycle.

3. A method according to claim 1 or 2, wherein the modulating is such that a within cycle phase of the modulated laser signal varies substantially periodically as a voltage of the analogue input signal increases.

4. A method according to claim 3, wherein the modulating is such that variation of the analogue input signal over its range causes the within cycle phase of the modulated laser signal to vary through multiple complete cycles.

5. A method according to any preceding claim, wherein:
the modulated laser signal has a plurality of possible phase states,
the modulating comprises causing the modulated laser signal to assume one of the plurality of possible phase states, the assumed phase state being associated with the analogue input voltage; and
the determining comprises evaluating the assumed phase state.

6. A method according to claim 5, wherein at least one of the plurality of possible phase states is associated with a plurality of possible voltages of the analogue input signal.

7. A method according to claim 6, wherein the determining comprises identifying which voltage in the plurality of possible voltages has caused the assumed phase state.

8. A method according to claim 7, wherein the identifying is performed on the basis of one or more previously determined voltages of the analogue input signal.

9. A method according to claim 7, wherein:
the method further comprises operating an analogue to digital converter to convert the analogue input signal into a digitised input signal; and
the identifying is performed on the basis of the digitised input signal.

10. A method according to any preceding claim, further comprising:
obtaining (703) a further laser signal;
modulating (707), using an electro-optic phase modulator, the further laser signal on the basis of the analogue input signal, such that modulation of the further laser signal is different to the modulation of the laser signal,
wherein the determining is performed further on the basis of the modulated further laser signal.

11. A method according to claims 7 and 10, wherein the identifying is performed on the basis of the modulated further laser signal.

12. A method according to claim 10 or 11, wherein the modulating of the further laser signal is such that the modulated further laser signal has a further plurality of possible phase states, each of the further plurality of possible phase states being associated with only a respective one of the plurality of possible voltages of the analogue input signal.

13. A method according to any preceding claim, wherein:
the method further comprises determining (709) a change in phase of the modulated laser signal; and
the determining of the change in voltage of the analogue input signal is performed on the basis of the determined change in phase.

14. A method according to claim 13, wherein:
determining the change in phase of the modulated laser signal comprises measuring a phase difference between the modulated laser signal on consecutive samples.
the measured phase difference is no more than half a cycle.

15. An apparatus (100) for performing analogue to digital conversion of an analogue input signal, the apparatus comprising:
an electro-optic phase modulator (105) configured receive a laser signal and modulate the laser signal on the basis of the analogue input signal; and
a processor (123) configured to determine, on the basis of the modulated laser signal, a change in voltage of the analogue input signal and generate a digital signal indicative of the determined voltage.
